(19) Europäisches Patentamt
European Patent Office
Office européen des brevets

(11) **EP 4 723 210 A1**

(12) **EUROPEAN PATENT APPLICATION**
published in accordance with Art. 153(4) EPC

(43) Date of publication:
**08.04.2026   Bulletin 2026/15**

(21) Application number: **23962615.3**

(22) Date of filing: **27.12.2023**

(51) International Patent Classification (IPC):
*H01M 4/36* (2006.01)          *H01M 4/505* (2010.01)
*H01M 4/525* (2010.01)          *C30B 1/00* (2006.01)

(52) Cooperative Patent Classification (CPC):
**C30B 1/00; H01M 4/36; H01M 4/505; H01M 4/525**

(86) International application number:
**PCT/CN2023/142331**

(87) International publication number:
**WO 2025/137927 (03.07.2025 Gazette 2025/27)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Beijing Easpring Material Technology Co., Ltd.**
**Beijing 100160 (CN)**

(72) Inventors:
• **HU, Yiseng**
**Beijing 100160 (CN)**
• **LI, Shanshan**
**Beijing 100160 (CN)**
• **SONG, Shunlin**
**Beijing 100160 (CN)**
• **LIU, Yafei**
**Beijing 100160 (CN)**
• **CHEN, Yanbin**
**Beijing 100160 (CN)**

(74) Representative: **Lavoix**
**Bayerstraße 83**
**80335 München (DE)**

(54) **SINGLE CRYSTAL POSITIVE ELECTRODE MATERIAL, PREPARATION METHOD THEREFOR, AND LITHIUM-ION BATTERY**

(57)    The present disclosure relates to the field of lithium-ion batteries and discloses a single crystal cathode material, a preparation method thereof, and a lithium-ion battery. The single crystal cathode material has a size distribution $B_{90}=(P_{90}-P_{10})/P_{50}$ of single crystal particles satisfying $0.9 \leq B_{90} \leq 1.4$. A Young's modulus E of the cathode material, measured by Atomic Force Microscopy, satisfies $100\ \text{GPa} \leq E \leq 200\ \text{GPa}$. The single crystal particles of the single crystal cathode material have a specific particle size distribution, enabling the single crystal cathode material to have a high compaction density, and to have a higher Young's modulus allowing the single crystal cathode material to withstand a higher rolling force during the preparation of the battery, thereby improving the volume energy density of the lithium-ion battery including the cathode material.

FIG. 1

**Description**

**FIELD**

The present disclosure relates to the field of lithium-ion batteries, and specifically, to a single crystal cathode material, a preparation method thereof, and a lithium-ion battery.

**BACKGROUND**

With the rapid development of the power battery industry, the market demand for lithium-ion batteries is also increasing. Due to the large size, an on-board battery occupies a lot of space in electric vehicles, which greatly limits comfort and design of the vehicle. A cathode material, as the largest component in the battery, can reduce the volume of the battery by improving the volume energy density thereof. Currently, the prior art often improves the energy density of the battery by increasing the operating voltage window. However, as the voltage increases, the performances of the battery will deteriorate significantly, and problems such as electrode pulverization, abrupt capacity fading during cycle, and gas generation during storage will often occur. At the same time, the existing electrolyte is highly prone to oxidative decomposition under high voltage, which also limits the further development of this solution.

By improving the compaction density of the cathode material and thus compressing more cathode materials per unit of space, the space can also be saved. Improving the compaction density means that the cathode material particles will be subjected to greater pressure during the preparation of the electrode plate. If the material particles are not strong enough, they will easily crack or even break under such pressure.

**SUMMARY**

An object of the present disclosure is to overcome the problem that the compaction density and particle strength of the cathode material in the prior art cannot meet the requirements. The present disclosure provides a single crystal cathode material, a preparation method thereof, and a lithium-ion battery. Single crystal particles of the single crystal cathode material have a specific particle size distribution, enabling the single crystal cathode material to have a high compaction density, and to have a higher Youngs modulus allowing the single crystal cathode material to withstand a higher rolling force during the preparation of the battery, thereby improving the volume energy density of the lithium-ion battery including the cathode material.

In order to achieve the above object, a first aspect of the present disclosure provides a single crystal cathode material. The single crystal cathode material has a size distribution $B_{90}=(P_{90}-P_{10})/P_{50}$ of single crystal particles satisfying $0.9 \leq B_{90} \leq 1.4$, where: $P_{10}$ is a particle size corresponding to cumulative single crystal particle size distribution percentage in a Scanning Electron Microscope, SEM, image of the cathode material reaching 10%; $P_{50}$ is a particle size corresponding to the cumulative single crystal particle size distribution percentage in the SEM image of the cathode material reaching 50%; and $P_{90}$ is a particle size corresponding to the cumulative single crystal particle size distribution percentage in the SEM image of the cathode material reaching 90%. A Youngs modulus E of the cathode material, measured by atomic force microscopy, satisfies $100 \text{ GPa} \leq E \leq 200 \text{ GPa}$.

A second aspect of the present disclosure provides a method for preparing the above-mentioned single crystal cathode material. The method includes: S1, mixing a nickel-cobalt-manganese precursor, a lithium source, and an additive optionally containing element G, to obtain a mixture I; S2, performing, in the presence of an oxygen-containing atmosphere, a first sintering and crushing on the mixture I, to obtain a single crystal cathode material process product II; S3, mixing the single crystal cathode material process product II with a coating agent optionally containing element M, to obtain a mixture III; and S4, performing, in the presence of an oxygen-containing atmosphere, a second sintering on the mixture III, to obtain the single crystal cathode material. Said crushing enables the size distribution $B_{90}=(P_{90}-P_{10})/P_{50}$ of single crystal particles of the single crystal cathode material to satisfy $0.9 \leq B_{90} \leq 1.4$. $P_{10}$ is a particle size corresponding to cumulative single crystal particle size distribution percentage in an SEM image of the cathode material reaching 10%, $P_{50}$ is a particle size corresponding to the cumulative single crystal particle size distribution percentage in the SEM image of the cathode material reaching 50%, and $P_{90}$ is a particle size corresponding to the cumulative single crystal particle size distribution percentage in the SEM image of the cathode material reaching 90%. The first sintering includes: a sintering temperature of $T/°C$, a duration for a temperature-rising section from 400°C to T being $t_1/h$, and a duration for a temperature-falling section from T to 400°C being $t_2/h$, and $t_2$ satisfying $[\ln(T-400)]/t_2 \leq 1$.

A third aspect of the present disclosure provides a lithium-ion battery. The lithium-ion battery includes the above-mentioned single crystal cathode material.

By means of the above-mentioned technical solution, the single crystal cathode material, the preparation method thereof, and the lithium-ion battery according to the present disclosure have the following beneficial effects.

In the present disclosure, it is found through SEM that the single crystal particles of the single crystal cathode material have a specific size distribution $B_{90}=(P_{90}-P_{10})/P_{50}$ and a suitable Youngs modulus strength, enabling the single crystal cathode material to have a high compaction density, and to withstand a higher rolling force during the preparation of the battery. In this way, the lithium-ion battery including the cathode material can have an improved volume energy density, a good cycle retention rate, and a low impedance.

In the method for preparing the cathode material according to the present disclosure, the single crystal cathode material can have a high compaction density by crushing the product obtained after the first sintering and controlling the single crystal particles of the single crystal cathode material to have a specific particle size distribution.

Furthermore, the Applicant found that by controlling the temperature to fall slowly, the solid phase reaction can be more complete, the particles can be more rounded and regular, the residual stress inside the particles can be reduced while the Youngs modulus is increased, and the strength of the particles can be increased. In this way, the material particles can withstand a higher rolling force during the preparation of the battery, thereby improving a volume energy density of the lithium-ion battery including the cathode material.

In addition, the method for preparing the cathode material according to the present disclosure is simple and easy to prepare industrially.

## BRIEF DESCRIPTION OF THE DRAWINGS

FIG. 1 is an SEM image of a single crystal cathode material of Example 1;
FIG. 2 is an SEM image of a single crystal cathode material of Example 6;
FIG. 3 is an SEM image of a single crystal cathode material of Example 1 after being subjected to a pressure treatment of 400 MPa;
FIG. 4 is an SEM image of a single crystal cathode material of Comparative Example 1 after being subjected to a pressure treatment of 400 MPa; and
FIG. 5 is an SEM image of a single crystal cathode material of Comparative Example 2 after being subjected to a pressure treatment of 400 MPa.

## DETAILED DESCRIPTION

The endpoints of the ranges and any values disclosed herein shall not limited to the exact ranges or values, and those ranges or values should be understood to include values close to those ranges or values. For numerical ranges, endpoints of the respective ranges, an endpoint of respective ranges and an individual point value, and individual point values may be combined with each other to obtain one or more new numerical ranges, which should be deemed to be specifically disclosed herein.

A first aspect of the present disclosure provides a single crystal cathode material. Single crystal particles of the single crystal cathode material have a size distribution of $B_{90}=(P_{90}-P_{10})/P_{50}$ satisfying $0.9 \leq B_{90} \leq 1.4$, where $P_{10}$ is a particle size corresponding to cumulative single crystal particle size distribution percentage in a Scanning Electron Microscope, SEM, image of the cathode material reaching 10%; $P_{50}$ is a particle size corresponding to the cumulative single crystal particle size distribution percentage in the SEM image of the cathode material reaching 50%; and $P_{90}$ is a particle size corresponding to the cumulative single crystal particle size distribution percentage in the SEM image of the cathode material reaching 90%. A Youngs modulus E of the cathode material, measured by atomic force microscopy, satisfies $100 \text{ GPa} \leq E \leq 200 \text{ GPa}$.

In the present disclosure, the single crystal particles of the single crystal cathode material have a specific size distribution, enabling the single crystal cathode material to have a high compaction density, and to have a higher Youngs modulus allowing the single crystal cathode material to withstand a higher rolling force during the preparation of the battery, thereby improving the volume energy density of the lithium-ion battery including the cathode material.

Specifically, if the size distribution of the single crystal particles becomes narrower, it indicates that the grading of the single crystal particles is poorer, and the compaction density will decrease. If the size distribution of the single crystal particles becomes wider, it indicates that the grading of the single crystal particles is better, and the compaction density will become higher. However, if the distribution is too wide, it indicates that there are many fine powders and large particles in the material, which is prone to powder loss or even abrupt capacity fading during the cycle of the battery. When the size distribution of the single crystal particles is controlled to satisfy the above-mentioned range, it indicates that there is good gradation between large and small particles in the cathode material, which allows the cathode material to have a high compaction density.

In the present disclosure, based on quantity, $P_{10}$ means that the size of 10% of the single crystal particles of the cathode material is smaller than $P_{10}$, $P_{50}$ means that the size of 50% of the single crystal particles of the cathode material is smaller than $P_{50}$, and $P_{90}$ means that the size of 90% of the single crystal particles of the cathode material is smaller than

$P_{90}$.

In the present disclosure, in the cathode material, 500 single crystal particles are randomly selected from the SEM image, and the average diameter is calculated after the projected area of the 500 single crystal particles is converted into a standard circle of equal area, that is, the particle size P of the single crystal cathode material. The random selection of the 500 particles may be obtained by cumulative selection in multiple SEM fields of view.

In the present disclosure, the Youngs modulus E refers to the magnitude of the force required to cause the particles to undergo unit deformation. The higher the test value, the more difficult it is to change the shape of the particles, that is, the greater the particle strength. In the present disclosure, the cathode material has a high Youngs modulus E, which makes the cathode material less prone to breakage during the rolling process of the electrode plate, and allows the cathode material to have a higher compaction density.

In the present disclosure, the Youngs modulus E of the cathode material is tested by Atomic Force Microscopy, AFM.

In the present disclosure, the size distribution $B_{90}=(P_{90}-P_{10})/P_{50}$ of the single crystal particles satisfies: $0.9 \leq B_{90} \leq 1.4$, for example, $B_{90}$ may be 0.9, 1, 1.1, 1.2, 1.3, 1.4, and a range consisting of any two of these values, preferably, $1 \leq B_{90} \leq 1.3$.

In the present disclosure, the Youngs modulus E of the cathode material measured by atomic force microscopy satisfies: 100 GPa $\leq E \leq$ 200 GPa, for example, the Youngs modulus E may be 100 GPa, 110 GPa, 120 GPa, 130 GPa, 140 GPa, 150 GPa, 160 GPa, 170 GPa, 180 GPa, 190 GPa, 200 GPa, and a range consisting of any two of these values, preferably, 120 GPa $\leq E \leq$ 200 GPa.

According to the present disclosure, 1 $\mu$m $\leq P_{50} \leq 2$ $\mu$m.

In the present disclosure, the Applicant found through research that if the particle size is too small, it indicates that there are more small particles, the compaction density will be reduced, and problems in processing and application aspects will be caused, such as increased viscosity, slurry jelly, and powder loss during the electrode plate cycle. If the particle size is too large, the transmission path of the lithium ions will increase, resulting in poor electrical performance, and at the same time, defects are more likely to appear in large particles, resulting in reduced particle strength. When $P_{50}$ is controlled within the above-mentioned range, the cathode material can have high compaction density, conductivity, and particle strength.

In the present disclosure, when $B_{90}$ remains unchanged, the larger the $P_{50}$ is, the greater the difference between large particles and small particles in the cathode material will be. When $P_{50} > 2$ $\mu$m, the internal residual stress will increase and the overall Youngs modulus will decrease due to the excessive size of the large particles, allowing the particles to be prone to breakage under the same compaction density. When $P_{50} < 1$ $\mu$m, the compaction density will decrease due to insufficient grading of large and small particles.

In the present disclosure, $P_{50}$ of the cathode material satisfies 1 $\mu$m $\leq P_{50} \leq 2$ $\mu$m, for example, it may be 1$\mu$m, 1.1$\mu$m, 1.2$\mu$m, 1.3$\mu$m, 1.4$\mu$m, 1.5$\mu$m, 1.6$\mu$m, 1.7$\mu$m, 1.8$\mu$m, 1.9$\mu$m, 2$\mu$m, and a range consisting of any two of these values, preferably, 1.3 $\mu$m $\leq P_{50} \leq 1.7$ $\mu$m.

According to the present disclosure, a coating ratio X of the cathode material, measured by SEM, satisfies 5% $\leq$ X.

In the present disclosure, by coating on the surface of the cathode material, the contact between the single crystal particles can be improved, thereby increasing the compaction density of the material. At the same time, the coating layer on the surface of the cathode material can also improve the particle strength of the material. Furthermore, when the coating ratio of the cathode material satisfies the above-mentioned range, the surface interface can be improved, the surface defects of the material can be compensated, and the Youngs modulus E and particle strength of the cathode material can be improved. However, if the coating ratio is too high, the interface of the electron transmission will be increased, and the impedance of the material will be increased.

In the present disclosure, the coating ratio X=total area of the coating agent on the surface of the single crystal particles/total surface area of the single crystal particles. The total area of the coating agent on the surface of the single crystal particles and the total area of the single crystal particles are measured by SEM images. Specifically, the total area of the single crystal particles is the total projected area of the coating agent on the surface of 100 random single crystal particles measured by SEM images, and the total area of the coating agent on the surface of the single crystal particles is the total projected area of 100 random corresponding single crystal particles measured by SEM images. The ratio of the two is the coating ratio.

In the present disclosure, the coating ratio X of the cathode material, measured by SEM, satisfies: 5% $\leq$ X, where X may be, for example, 5%, 6%, 7%, 8%, 9%, 10%, 15%, 20%, 25%, 30%, 35%, 40%, and a range consisting of any two of these values, preferably, 5% $\leq$ X $\leq$ 30%.

According to the present disclosure, a residual stress of the cathode material, measured by X-Ray Diffraction, XRD, ranges from 0% to 0.2%.

In the present disclosure, the cathode material has low residual stress, indicating that the cathode material has more internal defects and is not easy to break.

In the present disclosure, the residual stress of the cathode material is obtained by fine-tuning and calculating after XRD test.

In the present disclosure, the residual stress of the cathode material, measured by XRD, ranges from 0% to 0.2%, for example, it may be 0%, 0.01%, 0.02%, 0.03%, 0.04%, 0.05%, 0.06%, 0.07%, 0.08%, 0.09%, 0.1%, 0.11%, 0.12%, 0.13%, 0.14%, 0.15%, 0.16%, 0.17%, 0.18%, 0.19%, 0.2%, and a range consisting of any two of these values. Preferably, the residual stress of the cathode material, measured by XRD, ranges from 0.01% to 0.15%.

According to the present disclosure, a median particle size $D_{50}$ of the cathode material, measured by a particle size analyzer, satisfies $2 \mu m \leq D_{50} \leq 6 \mu m$, for example, it may be $2\mu m$, $2.2\mu m$, $2.4\mu m$, $2.6\mu m$, $2.8\mu m$, $3\mu m$, $3.2\mu m$, $3.4\mu m$, $3.6\mu m$, $4\mu m$, $4.2\mu m$, $4.4\mu m$, $4.6\mu m$, $4.8\mu m$, $5\mu m$, $5.2\mu m$, $5.4\mu m$, $5.6\mu m$, $5.8\mu m$, $6\mu m$, and a range consisting of any two of these values, preferably, $3 \mu m \leq D_{50} \leq 5 \mu m$.

According to the present disclosure, a particle size change rate $\Delta D_{10} = D_{10} - D_{10}$ of the cathode material subsequent to a pressure treatment at 400 MPa, measured by a particle size analyzer, satisfies $\Delta D_{10} \leq 0.2 \mu m$, where $D_{10}$ is a particle size before the pressure treatment, and $D_{10}$ is a particle size subsequent to the pressure treatment.

In the present disclosure, subsequent to a certain pressure treatment, the particle size change rate of the cathode material is relatively low, indicating that the cathode material has a high particle strength, and the cathode material particles are not easy to crush during the preparation of the battery.

According to the present disclosure, the cathode material has a compaction density ranging from 3.3 g/cm³ to 3.7 g/cm³.

In the present disclosure, the cathode material has a high compaction density and a high particle strength, and the battery prepared thereby has a high volume energy density.

According to the present disclosure, the single crystal cathode material has a composition represented by Formula I: $Li_{1+a}(Ni_xMn_yCo_zG_b)M_cO_2$ Formula I, where: $0 \leq a \leq 0.2$, $0 < b \leq 0.05$, $0 < c \leq 0.05$, $0.4 \leq x < 1$, $0 < y < 0.5$, and $0 \leq z < 0.5$; M is selected from at least one of B, Nb, Co, Mo, W, Si, Mg, and Al; and G is selected from at least one of Ta, Nb, Hf, Zr, Ti, Al, W, Y, Sb, Sr, and Si.

In the present disclosure, in addition to the element Li, the main elements distributed inside the single crystal cathode material particles are Ni, Co, Mn, and G, and the main metal element distributed on the surface of the single crystal cathode material particles is M.

In the present disclosure, the metal element M in the cathode material is the main metal element in the coating agent, and the coating agent includes a lithium oxygen compound of the element M and/or an oxide containing the element M, and may also include at least one element of Ni, Co, Mn, and G from the matrix.

In one specific embodiment of the present disclosure, M and G are different.

In one specific embodiment of the present disclosure, M is selected from at least one of Al, W, Nb, B, and Mg.

In one specific embodiment of the present disclosure, M is selected from at least one of Al, W, B, and Mg.

In one specific embodiment of the present disclosure, G is selected from at least one of Ta, Nb, Hf, Zr, Ti, Al, W, and Y.

In one preferred embodiment of the present disclosure, G satisfies $E_{G-O} \geq 500$ kJ/mol, where $E_{G-O}$ is the bond energy of G-O. In the present disclosure, when the element G which can bond with O and has a higher G-O bond energy is selected in the cathode material, G can enter into the interior of the crystal to participate in the lattice construction, allowing the Youngs modulus of the cathode material to be further improved. Preferably, G is selected from at least one of Ta, Nb, Hf, Zr, and Ti.

In one specific embodiment of the present disclosure, in Formula I, a may be 0, 0.01, 0.02, 0.03, 0.04, 0.05, 0.06, 0.07, 0.08, 0.09, 0.1, 0.12, 0.14, 0.16, 0.18, 0.2, and a range consisting of any two of these values, and preferably, $0 < a < 0.1$; b may be 0.01, 0.02, 0.03, 0.04, 0.05, and a range consisting of any two of these values, and preferably, $0 < b < 0.03$; and c may be 0.01, 0.02, 0.03, 0.04, 0.05, and a range consisting of any two of these values, and preferably, $0 < c \leq 0.03$.

A second aspect of the present disclosure provides a method for preparing the above-mentioned single crystal cathode material. The method includes: S1, mixing a nickel-cobalt-manganese precursor, a lithium source, and an additive optionally containing element G, to obtain a mixture I; S2, performing, in the presence of an oxygen-containing atmosphere, a first sintering and crushing on the mixture I, to obtain a single crystal cathode material process product II; S3, mixing the single crystal cathode material process product II with a coating agent optionally containing element M, to obtain a mixture III; and S4, performing, in the presence of an oxygen-containing atmosphere, a second sintering on the mixture III, to obtain the single crystal cathode material. Said crushing enables the size distribution $B_{90} = (P_{90} - P_{10})/P_{50}$ of the single crystal particles of the single crystal cathode material to satisfy $0.9 \leq B_{90} \leq 1.4$. $P_{10}$ is a particle size corresponding to cumulative single crystal particle size distribution percentage in an SEM image of the cathode material reaching 10%; $P_{50}$ is a particle size corresponding to the cumulative single crystal particle size distribution percentage in the SEM image of the cathode material reaching 50%; and $P_{90}$ is a particle size corresponding to the cumulative single crystal particle size distribution percentage in the SEM image of the cathode material reaching 90%. The first sintering includes: a sintering temperature of T/°C, a duration for a temperature-rising section from 400°C to T being $t_1$/h, and a duration for a temperature-falling section from T to 400°C being $t_2$/h, and $t_2$ satisfying $[ln(T-400)]/t_2 \leq 1$.

In the present disclosure, the single crystal cathode material can have a high compaction density by crushing the product obtained after the first sintering, controlling the single crystal particles of the single crystal cathode material to have a specific particle size distribution, and controlling the duration for the temperature-falling section in the first sintering, thereby improving the volume energy density of the lithium-ion battery including the cathode material.

Specifically, when controlling the duration for the temperature-falling section in the first sintering to satisfy the above-mentioned range, the temperature-falling rate of the temperature-falling section is low. The Applicant found through research that by controlling the temperature to fall slowly, the solid phase reaction can be more complete, the particles can be more rounded and regular, the residual stress inside the particles can be reduced while the Youngs modulus is increased, and the strength of the particles can be increased. In this way, the material can withstand higher rolling force during the preparation of the battery, thereby ensuring that cathode particles do not break when preparing the lithium-ion battery with high volume energy density.

In the present disclosure, there is no particular limitation on the device and/or conditions, etc., for the crushing, as long as the size distribution $B_{90}$ of the single crystal particles of the single crystal cathode material can satisfy the definition of the present disclosure.

In the present disclosure, $t_2$ satisfies $[ln(T-400)]/t_2 \leq 1$, for example, it may be 1, 0.9, 0.8, 0.7, 0.6, 0.5, 0.4, 0.3, 0.2, 0.1, and a range consisting of any two of these values. Preferably, $t_2$ satisfies $[ln(T-400)]/t_2 \leq 0.9$. In this relationship, the unit of T is °C, and the unit of $t_2$ is h, which reflects the relationship between the sintering temperature T and the temperature-falling duration $t_2$ and limits the temperature-falling rate.

According to the present disclosure, $0 < t_1/t_2 \leq 1$.

In the present disclosure, when controlling the duration $t_1$ for the temperature-rising section and the duration $t_2$ for the temperature-falling section to satisfy the above-mentioned range, it indicates that in the first sintering process, the material has the characteristics of fast temperature rising and slow temperature falling, which can lead to an increase in the Youngs modulus of the prepared cathode material particles and a further reduction in the residual stress inside the particles.

In the present disclosure, $0 < t_1/t_2 \leq 1$, for example, $t_1/t_2$ may be 0.1, 0.2, 0.3, 0.4, 0.5, 0.6, 0.7, 0.8, 0.9, 1, and a range consisting of any two of these values, preferably, $0.1 \leq t_1/t_2 \leq 0.8$.

According to the present disclosure, 800°C<T<1000°C.

In the present disclosure, the particle size $P_{50}$ can be controlled by controlling the sintering temperature T of the first sintering. When the sintering temperature T satisfies the above-mentioned range, the obtained particle size is moderate. If the temperature is too high, the particle size will increase, and the capacity will decrease; and at the same time, if the temperature is too low, the particle size will decrease, and the cycle performance will become poor.

In the present disclosure, the sintering temperature T of the first sintering satisfies $800°C \leq T \leq 1000°C$, for example, it may be 800°C, 810°C, 820°C, 830°C, 840°C, 850°C, 860°C, 870°C, 880°C, 890°C, 900°C, 910°C, 920°C, 930°C, 940°C, 950°C, 960°C, 970°C, 980°C, 990°C, 1000°C, and a range consisting of any two of these values, preferably, $850°C \leq T \leq 970°C$.

According to the present disclosure, in step S1, the additive containing the element G is selected from at least one of an oxide of G, a hydroxide of G, and a carbonate of G.

According to the present disclosure, the element G is selected from at least one of Ta, Nb, Hf, Zr, Ti, Al, W, Y, Sb, Sr, and Si.

In a specific embodiment of the present disclosure, G is selected from at least one of Ta, Nb, Hf, Zr, Ti, Al, W, and Y.

According to the present disclosure, G satisfies $E_{G-O} \geq 500$ kJ/mol, where $E_{G-O}$ is a bond energy of G-O.

In the present disclosure, when a compound containing the element G that can bond with O and has a higher G-O bond energy is selected as an additive, G can enter into the interior of the crystal to participate in the lattice construction, allowing the Youngs modulus of the cathode material to be further improved. Preferably, G is selected from at least one of Ta, Nb, Hf, Zr, and Ti.

According to the present disclosure, amounts of the nickel-cobalt-manganese precursor, the lithium source, and the additive containing the element G satisfy $1 \leq n(Li)/[n(Ni)+n(Co)+n(Mn)] \leq 1.2$ and $0 < n(G)/[n(Ni)+n(Co)+n(Mn)] \leq 0.05$.

Furthermore, the amounts of the nickel-cobalt-manganese precursor, the lithium source, and the additive containing the element G satisfy $1 \leq n(Li)/[n(Ni)+n(Co)+n(Mn)] \leq 1.1$ and $0 < n(G)/[n(Ni)+n(Co)+n(Mn)] \leq 0.03$.

In the present disclosure, the nickel-cobalt-manganese precursor is selected from a nickel-cobalt-manganese oxide and/or a nickel-cobalt-manganese hydroxide.

In the present disclosure, there is no particular limitation on the type of the lithium source, and conventional lithium sources in the art, such as lithium carbonate and/or lithium hydroxide, may be used.

According to the present disclosure, the element M is selected from at least one of B, Nb, Co, Mo, W, Si, Mg, and Al.

In one specific embodiment of the present disclosure, the element M is different from the element G.

In one specific embodiment of the present disclosure, the element M is selected from at least one of Al, W, B, and Mg.

In the present disclosure, there is no particular limitation on the type of the coating agent, as long as it can provide the element M, such as an oxide, hydroxide, or carbonate containing the element M.

According to the present disclosure, amounts of the single crystal cathode material process product II and the coating agent containing the element M satisfy $0<n(M)/[n(Ni)+n(Co)+n(Mn)]<0.05$.

Furthermore, the amounts of the single crystal cathode material process product II and the coating agent containing the element M satisfy $0<n(M)/[n(Ni)+n(Co)+n(Mn)]<0.03$.

According to the present disclosure, conditions for the second sintering include: a sintering temperature ranging from 300°C to 800°C and a sintering duration ranging from 4 hours to 12 hours.

Further, the conditions for the second sintering include: a sintering temperature ranging from 400°C to 750°C and a sintering duration ranging from 6 hours to 10 hours.

In the present disclosure, the oxygen-containing atmosphere is oxygen and/or air.

In the present disclosure, there is no particular requirement for the device used for the crushing, and it may be any conventional device capable of crushing in the art, such as one or more of a soymilk machine, a jaw crusher, a roller crusher, a colloid mill, a mechanical mill, and a jet mill.

In the present disclosure, the method further includes crushing and sieving the product obtained after the second sintering.

A third aspect of the present disclosure provides a lithium-ion battery. The lithium-ion battery includes the above-mentioned single crystal cathode material.

The present disclosure will be described in detail below by means of examples. In the following examples, the raw materials used in the examples and the comparative examples are all commercially available products.

**Example 1**

1) Preparation of a process product of a cathode material: a nickel-cobalt-manganese hydroxide precursor $(Ni_{0.6}Co_{0.2}Mn_{0.2})(OH)_2$ was mixed evenly with lithium carbonate and an additive $ZrO_2$ according to a ratio of $[n(Ni)+n(Co)+n(Mn)]: n(Li): n(Zr)=1: 1.04: 0.002$ using a high-speed mixer; and then the mixture was subjected to a sintering under an oxygen atmosphere. The sintering process was as follows: raising the temperature to 970°C, holding at 970°C for 10 hours, and then cooling down, where a duration $t_1$ for the temperature rising from 400°C to 970°C was 6 hours, and a duration for the temperature falling from 970°C to 400°C was 8 hours. After sintering, a sintered material was crushed by a jet mill, to obtain the process product of the cathode material.

2) Preparation of a finished product of a cathode material: the process product of the cathode material obtained by the above method was mixed evenly with a coating agent $WO_3$ according to a ratio of $[n(Ni)+n(Co)+n(Mn)]: n(M)=1: 0.01$ using a high-speed mixer; and then the mixture was subjected to a sintering under an air atmosphere. The sintering process was as follows: raising the temperature to 500°C and holding at 500°C for 8 hours. After sintering, a sintered material was crushed by a colloid mill, to obtain the finished product of the cathode material with a $D_{50}$ of 3.8 $\mu$m.

**Example 2**

Except that the sintering temperature in step 1) was adjusted to 940°C, the other process parameters were identical to those in Example 1, as shown in Table 2 for details.

**Example 3**

Except that in step 1), the composition of the precursor was adjusted to $(Ni_{0.8}Co_{0.1}Mn_{0.1})(OH)_2$, the lithium source was adjusted to lithium hydroxide, the addition amounts satisfied: $[n(Ni)+n(Co)+n(Mn)]: n(Li): n(Zr)=1: 1.03: 0.002$, and the sintering temperature was adjusted to 890°C; and in step 2), $WO_3$ was replaced with $Co(OH)_2$, and the sintering temperature was increased to 700°C, the other process parameters were identical to those in Example 1, as shown in Table 2 for details.

**Example 4**

Except that in step 2) the ratio of the process product of the cathode material to the coating agent $WO_3$ was adjusted to $[n(Ni)+n(Co)+n(Mn)]: n(M)=1: 0.04$, the other process parameters were identical to those in Example 1, as shown in Table 2 for details.

**Example 5**

Except that in step 1) the sintering temperature was adjusted to 1050°C, the other process parameters were identical to those in Example 1, as shown in Table 2 for details.

**Example 6**

Except that in step 2) the process product of the cathode material was mixed evenly with the coating agent according to a ratio of [n(Ni)+n(Co)+n(Mn)]: n(M)=1: 0.0005 using a high-speed mixer, the other process parameters were identical to those in Example 1, as shown in Table 2 for details.

**Example** 7

Except that in step 1) the additive was replaced with $TiO_2$ and mixed evenly according to a ratio of [n(Ni)+n(Co)+n(Mn)]: n(Li): n(Ti)=1: 1.04: 0.002 using a high-speed mixer, the other process parameters were identical to those in Example 1, as shown in Table 2 for details.

Example 8

In step 1), the additives were replaced with $Y_2O_3$ and $Al_2O_3$ and mixed evenly according to a ratio of [n(Ni)+n(Co)+n(Mn)]: n(Li): n(Y): n(Al)=1: 1.04: 0.001: 0.001 using a high-speed mixer, the sintering temperature was 960°C, $t_1$ was 5 hours, and $t_2$ was 7 hours. In step 2), the coating agent was replaced with $B_2O_3$ and mixed evenly according to a ratio of [n(Ni)+n(Co)+n(Mn)]: n(M)=1: 0.005 using a high-speed mixer, and the sintering temperature was 350°C. The other process parameters were shown in Table 2 for details.

Example 9

In step 1), the additive was replaced with $Al_2O_3$ and mixed evenly according to a ratio of [n(Ni)+n(Co)+n(Mn)]: n(Li): n(Al)=1: 1.04: 0.002 using a high-speed mixer, the sintering temperature was 940°C, $t_1$ was 5 hours, and $t_2$ was 9 hours. In step 2), the coating agents were replaced with $B_2O_3$ and $WO_3$ and mixed evenly according to a ratio of [n(Ni)+n(Co)+n(Mn)]: n(B): n(W)=1: 0.001: 0.001 using a high-speed mixer, and the sintering temperature was 400°C. The other process parameters were shown in Table 2 for details.

**Comparative Example 1**

Except that in step 1) the crushing strength during the crushing process was increased, to obtain a finished product with a particle distribution $B_{90}$ of 0.83, the other process parameters were identical to those in Example 1, as shown in Table 2 for details.

**Comparative Example 2**

Except that in step 1) the duration $t_2$ for the temperature falling to 400°C was 4 hours, the other process parameters were identical to those in Example 1, as shown in Table 2 for details.

[Table 1]

| Item | Nickel-cobalt-manganese precursor | Process product of cathode material | Cathode material |
|---|---|---|---|
| Example 1 | $(Ni_{0.6}Co_{0.2}Mn_{0.2})(OH)_2$ | $Li_{1.04}(Ni_{0.6}Mn_{0.2}Co_{0.2}Zr_{0.002})O_2$ | $Li_{1.04}(Ni_{0.6}Mn_{0.2}Co_{0.2}Zr_{0.002})W_{0.01}O_2$ |
| Example 2 | $(Ni_{0.6}Co_{0.2}Mn_{0.2})(OH)_2$ | $Li_{1.04}(Ni_{0.6}Mn_{0.2}Co_{0.2}Zr_{0.002})O_2$ | $Li_{1.04}(Ni_{0.6}Mn_{0.2}Co_{0.2}Zr_{0.002})W_{0.01}O_2$ |
| Example 3 | $(Ni_{0.8}Co_{0.1}Mn_{0.1})(OH)_2$ | $Li_{1.03}(Ni_{0.8}Mn_{0.1}Co_{0.1}Zr_{0.002})O_2$ | $Li_{1.03}(Ni_{0.8}Mn_{0.1}Co_{0.1}Zr_{0.002})Co_{0.01}O_2$ |
| Example 4 | $(Ni_{0.6}Co_{0.2}Mn_{0.2})(OH)_2$ | $Li_{1.04}(Ni_{0.6}Mn_{0.2}Co_{0.2}Zr_{0.002})O_2$ | $Li_{1.04}(Ni_{0.6}Mn_{0.2}Co_{0.2}Zr_{0.002})W_{0.04}O_2$ |

(continued)

| Item | Nickel-cobalt-manganese precursor | Process product of cathode material | Cathode material |
|---|---|---|---|
| Example 5 | $(Ni_{0.6}Co_{0.2}Mn_{0.2})(OH)_2$ | $Li_{1.04}(Ni_{0.6}Mn_{0.2}Co_{0.2}Zr_{0.002})O_2$ | $Li_{1.04}(Ni_{0.6}Mn_{0.2}Co_{0.2}Zr_{0.002})W_{0.01}O_2$ |
| Example 6 | $(Ni_{0.6}Co_{0.2}Mn_{0.2})(OH)_2$ | $Li_{1.04}(Ni_{0.6}Mn_{0.2}Co_{0.2}Zr_{0.002})O_2$ | $Li_{1.04}(Ni_{0.6}Mn_{0.2}Co_{0.2}Zr_{0.002})W_{0.0005}O_2$ |
| Example 7 | $(Ni_{0.6}Co_{0.2}Mn_{0.2})(OH)_2$ | $Li_{1.04}(Ni_{0.6}Mn_{0.2}Co_{0.2}Ti_{0.002})O_2$ | $Li_{1.04}(Ni_{0.6}Mn_{0.2}Co_{0.2}Ti_{0.002})W_{0.01}O_2$ |
| Example 8 | $(Ni_{0.6}Co_{0.2}Mn_{0.2})(OH)_2$ | $Li_{1.04}(Ni_{0.6}Mn_{0.2}Co_{0.2}Y_{0.001}Al_{0.001})O_2$ | $Li_{1.04}(Ni_{0.6}Mn_{0.2}Co_{0.2}Y_{0.001}Al_{0.001})B_{0.005}O_2$ |
| Example 9 | $(Ni_{0.6}Co_{0.2}Mn_{0.2})(OH)_2$ | $Li_{1.04}(Ni_{0.6}Mn_{0.2}Co_{0.2}Al_{0.002})O_2$ | $Li_{1.04}(Ni_{0.6}Mn_{0.2}Co_{0.2}Al_{0.002})B_{0.001}W_{0.001}O_2$ |
| Comparative Example 1 | $(Ni_{0.6}Co_{0.2}Mn_{0.2})(OH)_2$ | $Li_{1.04}(Ni_{0.6}Mn_{0.2}Co_{0.2}Zr_{0.002})O_2$ | $Li_{1.04}(Ni_{0.6}Mn_{0.2}Co_{0.2}Zr_{0.002})_{0.01}O_2$ |
| Comparative Example 2 | $(Ni_{0.6}Co_{0.2}Mn_{0.2})(OH)_2$ | $Li_{1.04}(Ni_{0.6}Mn_{0.2}Co_{0.2}Zr_{0.002})O_2$ | $Li_{1.04}(Ni_{0.6}Mn_{0.2}Co_{0.2}Zr_{0.002})W_{0.01}O_2$ |

[Table 2]

| Item | | Example 1 | Example 2 | Example 3 | Example 4 |
|---|---|---|---|---|---|
| n(Ni): n(Co): n(Mn) | | 60: 20: 20 | 60: 20: 20 | 80: 10: 10 | 60: 20: 20 |
| Type of lithium source | | Lithium carbonate | Lithium carbonate | Lithium hydroxide | Lithium carbonate |
| Type of additive | | $ZrO_2$ | $ZrO_2$ | $ZrO_2$ | $ZrO_2$ |
| Lithium salt: precursor: additive | | 1.04: 1: 0.002 | 1.04: 1: 0.002 | 1.03: 1: 0.002 | 1.04: 1: 0.002 |
| First sintering | Sintering atmosphere | Oxygen | Oxygen | Oxygen | Oxygen |
| | Constant temperature T/°C | 970 | 940 | 890 | 970 |
| | Constant temperature duration t/h | 10 | 10 | 10 | 10 |
| | Duration for temperature rising from 400°C to T: $t_1$ | 6 | 6 | 6 | 6 |
| | Duration for temperature falling from T to 400°C: $t_2$ | 8 | 8 | 8 | 8 |
| Coating agent M | | $WO_3$ | $WO_3$ | $Co(OH)_2$ | $WO_3$ |
| [n(Ni)+n(Co)+n(Mn)]: n(M) | | 1: 0.01 | 1: 0.01 | 1: 0.01 | 1: 0.04 |
| Second sintering | Sintering atmosphere | Air | Air | Air | Air |
| | Constant temperature $T_2$/°C | 500 | 500 | 700 | 500 |
| | Constant temperature duration $t_2$/h | 8 | 8 | 8 | 8 |

[Table 2 continued]

| Item | Example 5 | Example 6 | Example 7 |
|---|---|---|---|
| n(Ni): n(Co): n(Mn) | 60: 20: 20 | 60: 20: 20 | 60: 20: 20 |
| Type of lithium source | Lithium carbonate | Lithium carbonate | Lithium carbonate |
| Type of additive | $ZrO_2$ | $ZrO_2$ | $TiO_2$ |
| Lithium salt: precursor: additive | 1.04: 1: 0.002 | 1.04: 1: 0.002 | 1.04: 1: 0.002 |

(continued)

| Item | | | Example 5 | Example 6 | Example 7 | |
|---|---|---|---|---|---|---|
| First sintering | Sintering atmosphere | | Oxygen | Oxygen | Oxygen | |
| | | Constant temperature T/°C | 1050 | 970 | 970 | |
| | | Constant temperature duration t/h | 10 | 10 | 10 | |
| | | Duration for temperature rising from 400°C to T: $t_1$ | 6 | 6 | 6 | |
| | | Duration for temperature falling from T to 400°C: $t_2$ | 8 | 8 | 8 | |
| Coating agent M | | | | $WO_3$ | $WO_3$ | $WO_3$ |
| [n(Ni)+n(Co)+n(Mn)]: n(M) | | | | 1: 0.01 | 1: 0.0005 | 1: 0.01 |
| Second sintering | | Sintering atmosphere | | Air | Air | Air |
| | | Constant temperature $T_2$/°C | | 500 | 500 | 500 |
| | | Constant temperature duration $t_2$/h | | 8 | 8 | 8 |

[Table 2 continued]

| Item | | | Example 8 | Example 9 | Comparative Example 1 | Comparative Example 2 |
|---|---|---|---|---|---|---|
| n(Ni): n(Co): n(Mn) | | | 60: 20: 20 | 60: 20: 20 | 60: 20: 20 | 60: 20: 20 |
| Type of lithium source | | | Lithium carbonate | Lithium carbonate | Lithium carbonate | Lithium carbonate |
| Type of additive | | | $Y_2O_3$, $Al_2O_3$ | $Al_2O_3$ | $ZrO_2$ | $ZrO_2$ |
| Lithium salt: precursor: additive | | | 1.04: 1: 0.001: 0.001 | 1.04: 1: 0.002 | 1.04: 1: 0.002 | 1.04: 1: 0.002 |
| First sintering | | Sintering atmosphere | Oxygen | Oxygen | Oxygen | Oxygen |
| | | Constant temperature T/°C | 960 | 940 | 970 | 970 |
| | | Constant temperature duration t/h | 10 | 10 | 10 | 10 |
| | | Duration for temperature rising from 400°C to T: $t_1$ | 5 | 5 | 6 | 6 |
| | | Duration for temperature falling from T to 400°C: $t_2$ | 7 | 9 | 8 | 4 |
| Coating agent M | | | $B_2O_3$ | $B_2O_3$, $WO_3$ | $WO_3$ | $WO_3$ |
| [n(Ni)+n(Co)+n(Mn)]: n(M) | | | 1: 0.005 | 1: 0.001: 0.001 | 1: 0.01 | 1: 0.01 |
| Second sintering | | Sintering atmosphere | Air | Air | Air | Air |
| | | Constant temperature $T_2$/°C | 350 | 400 | 500 | 500 |
| | | Constant temperature duration $t_2$/h | 8 | 8 | 8 | 8 |

**Test and device:**

① Particle size $D_{10}$, $D_{50}$, $D_{10}$: obtained by testing with Marverns Hydro 2000mu laser particle size analyzer.

② Compaction density (hereinafter referred to as PD): obtained by testing with a compaction density tester from Baxter Company, model BT-30.

Pressure test: the pressure test was carried out by Carver compaction density tester, and the test method was: first, accurately weighing 3 g of sample and placing the sample into the compaction mold, and covering the mold with the upper anvil and plunger; then, slowly pressurizing to 7.5 t, pressurizing for 10 minutes, keeping constant pressure for 30 seconds, and testing $D_{10}$ of the sample after pressure treatment.

③ Electron microscope test: obtained by Scanning Electron Microscope from model S-4800 of Hitachi, Japan.

The projected area of each single crystal particle in the electron microscope was counted with the help of measurement software, and then the particle size was obtained by calculation. The specific method was as follows. The average diameter calculated by converting the projection area of 500 random particles in the Scanning Electron Microscope image into a standard circle of equal area was the particle size P of the single crystal cathode material. The diameter data of the above 500 particles was statistically calculated, to obtain the particle size $P_{10}$ corresponding to the cumulative single crystal particle size distribution percentage of the sample reaching 10%, the particle size $P_{50}$ corresponding to the cumulative single crystal particle size distribution percentage of the sample reaching 50%, the particle size $P_{90}$ corresponding to the cumulative single crystal particle size distribution percentage of the sample reaching 90%, and the size distribution $B_{90}=(P_{90}-P_{10})/P_{50}$ of the single crystal particle. 500 particles were randomly selected, which may be obtained by cumulative selection in multiple Scanning Electron Microscope fields of view.

The total projected area of 100 single crystal particles and the total projected area of the coating agent on the surfaces of 100 single crystal particles were counted by measuring software, and the coating rate X = total area of the coating agent on the surface of the single crystal particles / total area of the single crystal particles.

The crack condition of the cross section of the cathode material was observed through the SEM image of the cross section.

④ Youngs modulus: the Youngs modulus was obtained by observing with Bruker Atomic Force Microscope and testing with Keysights Agilent Nano Indenter G200. Ten particles were randomly selected from each batch of samples for testing and the average value was taken, which was the Youngs modulus E of the material.

⑤ Residual stress: the residual stress was tested by Rigaku Rotating-Anode Diffractometer Smartlab 9KW and calculated by XRD refinement; and

⑥ Preparation of the battery and electrical performance tests:

In the above examples and comparative examples, the electrochemical performance of the cathode material was tested using a CR2025 button battery, and the preparation process thereof was as follows:

Preparation of an electrode plate: the cathode material, conductive carbon black, and polyvinylidene fluoride (PVDF) according to a mass ratio of 95 : 3 : 2 were fully mixed with an appropriate amount of N-methylpyrrolidone (NMP), to form an even electrode slurry (with a solid content of 60% at 25°C). The slurry was coated on an aluminum foil and dried at 120°C for 12 hours. Then the slurry was stamped and formed using a pressure of 100 MPa, to prepare a positive electrode plate with a diameter of 15.8 mm and a thickness of 3.2 mm. The loading of the cathode material was 15.5 mg/cm$^2$. In an argon-filled glove box with a water content and an oxygen content of less than 5 ppm, the positive electrode plate, a separator, a negative electrode plate, and an electrolyte were assembled into the CR2025 button battery and left to stand for 6 hours. A metal lithium plate with a diameter of 15.8 mm and a thickness of 1 mm was used as the negative electrode plate; a polypropylene microporous membrane (Celgard 2325) with a thickness of 25 $\mu$m was used as the separator; and a mixture of equal amounts of 1 mol/L LiPF$_6$, ethylene carbonate (EC), and diethyl carbonate (DEC) was used as the electrolyte.

Capacity test: the electrochemical performance of CR2025 button battery was tested using Shenzhen Xinweier Battery Test System, and the charge and discharge current density at 0.1 C was 100 mA/g. The charge and discharge voltage range was controlled to range from 3.0 V to 4.45 V. At room temperature, the button battery was subjected to a charge and discharge test at 0.1 C, to evaluate the charge and discharge specific capacity of the cathode material. Example 3 was a high nickel material, and the test voltage ranged from 3.0 V to 4.35 V.

High temperature cycle performance test: in both the examples and the comparative examples, the charge and discharge voltage range was controlled to range from 3.0 V to 4.45 V. At a constant temperature of 60°C, the button battery was charged and discharged twice at 0.1 C, and then charged and discharged for 80 times at 1 C, to evaluate the high temperature cycle capacity retention rate of the cathode material.

Impedance test: before the high temperature cycle test of the battery, the battery was fully charged, and the impedance at 50% SOC of the battery was tested, which was the initial impedance. After the high temperature cycle test of the battery, the battery was fully charged, and the impedance at 50% SOC of the battery was tested again, which was the final impedance. The impedance growth rate = (final impedance - initial impedance) / initial impedance $\times$ 100%.

[Table 3]

| Item | Particle size $D_{50}$ | Compaction density | Coating ratio | Young's modulus | Particle size | Particle distribution | $D_{10}$ difference before and after pressure test | Residual stress |
|---|---|---|---|---|---|---|---|---|
| | | PD | | E | $P_{50}$ | $B_{90}$ | $\Delta D_{10}=D_{10}-D'_{10}$ | |
| Unit | $\mu$m | g/cm$^3$ | % | GPa | $\mu$m | / | $\mu$m | % |
| Example 1 | 3.8 | 3.51 | 11.4 | 153 | 1.72 | 1.09 | 0.05 | 0.05 |
| Example 2 | 3.7 | 3.45 | 10.6 | 142 | 1.24 | 1.23 | 0.08 | 0.08 |
| Example 3 | 3.4 | 3.39 | 14.2 | 134 | 1.42 | 1.19 | 0.11 | 0.15 |
| Example 4 | 3.8 | 3.56 | 48.6 | 165 | 1.78 | 1.08 | 0.03 | 0.03 |
| Example 5 | 3.8 | 3.54 | 8.9 | 114 | 2.46 | 1.31 | 0.18 | 0.18 |
| Example 6 | 3.8 | 3.33 | 1.5 | 119 | 1.77 | 1.19 | 0.24 | 0.27 |
| Example 7 | 3.8 | 3.46 | 10.7 | 132 | 1.72 | 1.21 | 0.17 | 0.10 |
| Example 8 | 3.7 | 3.42 | 7.9 | 121 | 1.76 | 1.17 | 0.27 | 0.08 |
| Example 9 | 3.8 | 3.41 | 5.9 | 108 | 1.69 | 1.20 | 0.32 | 0.11 |
| Comparative Example 1 | 3.7 | 3.21 | 10.4 | 87 | 1.67 | 0.83 | 0.51 | 0.45 |
| Comparative Example 2 | 3.9 | 3.38 | 11.9 | 94 | 1.71 | 1.47 | 0.43 | 0.33 |

[Table 3 continued]

| Item | Capacity | High temperature cycle retention rate | Impedance | |
|---|---|---|---|---|
| | 0.1C | | Initial value | Growth rate |
| Unit | mAh/g | % | $\Omega$ | / |
| Example 1 | 200.9 | 96.3 | 18.4 | 109% |
| Example 2 | 201.1 | 95.4 | 17.8 | 119% |
| Example 3 | 209.8 | 95.3 | 18.2 | 120% |
| Example 4 | 201.6 | 96.2 | 19.2 | 134% |
| Example 5 | 197.8 | 95.7 | 21.0 | 196% |
| Example 6 | 198.6 | 95.2 | 21.9 | 165% |
| Example 7 | 199.9 | 95.8 | 19.9 | 145% |
| Example 8 | 199.2 | 95.1 | 20.4 | 167% |
| Example 9 | 200.1 | 94.6 | 20.1 | 188% |
| Comparative Example 1 | 196.4 | 89.4 | 25.8 | 353% |
| Comparative Example 2 | 197.2 | 91.3 | 23.9 | 276% |

Table 3 reveals that the single crystal cathode material according to the present disclosure has a specific particle size distribution $B_{90}$ and a high Youngs modulus, which allows the assembled button battery to have a high capacity, an excellent high temperature cycle retention rate, and a low impedance performance. That is, according to the method of the present disclosure, by adjusting the conditions for the first sintering, the residual stress inside the single crystal particles can be eliminated, thereby improving the particle strength of the cathode material.

By contrast, in the single crystal cathode material provided in Comparative Example 2, since the temperature-falling rate of the first sintering in the preparation process is too fast, not only can the existing internal stress not be eliminated, but the sudden cooling during the temperature-falling process will also cause new stress and strain, which ultimately leads to excessively high residual stress inside the particles and low Youngs modulus, that is, reduced hardness. In addition, during the preparation and cycle of the battery, the edges and corners on the surface of the particles are easily broken during the rolling process, and cracks are more likely to appear inside the particles, resulting in poor cycle performance and a significant increase in impedance after the cycle.

Comparative Example 1 is based on Example 1, and the particle size distribution $B_{90}$ is adjusted by adjusting the crushing strength after the first sintering. When the particle size is the same, a small $B_{90}$ indicates that the grading of the material particles is poor, which leads to a low compaction density. If the crushing strength is high during the preparation process, the surface/interior of the particles will be damaged, which allows the residual stress to be large and the particle strength to be low. At the same time, the larger crushing strength will inevitably bring fine powder/micro powder, resulting in a decrease in high temperature cycle retention rate and an increase in impedance.

Furthermore, through the change value $\Delta D_{10}=D_{10}-D_{10}$ of the particle size $D_{10}$ of the cathode material before and after the pressure test, it was found that the particles of the cathode material would be broken after the pressure test, resulting in a decrease in the $D_{10}$ value after the pressure test compared to the $D_{10}$ before the pressure test. The smaller the hardness of the material and the easier it is to break, the larger $\Delta D_{10}$ value will be. Compared with the examples, the comparative examples have smaller Youngs modul i, the particles thereof are more easily crushed, and accordingly, the $\Delta D_{10}$ values also vary greatly.

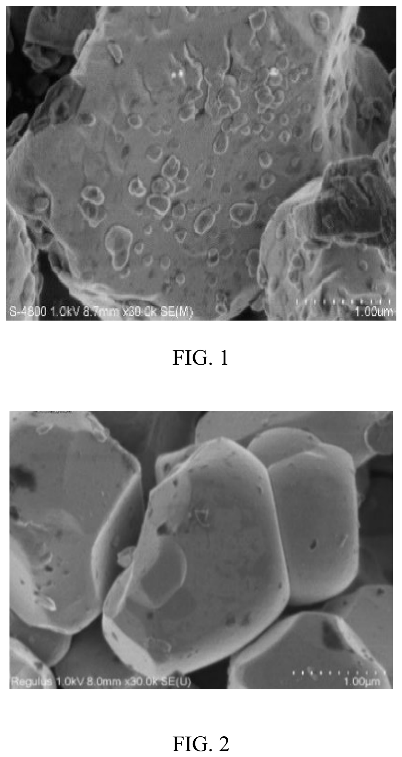

FIG. 1 is an SEM image of the single crystal cathode material of Example 1. The raised islands on the surface of the material are coating agent particles, which can improve the compaction density of the cathode material, and can also share the force exerted on the material particles and improve the particle strength thereof. FIG. 2 is an SEM image of the single crystal cathode material of Example 6. Due to the less addition amount of the coating agent, there are almost no coating agent particles on the surface of the material. Accordingly, the compaction density of Example 6 is low and the particle strength is also poor.

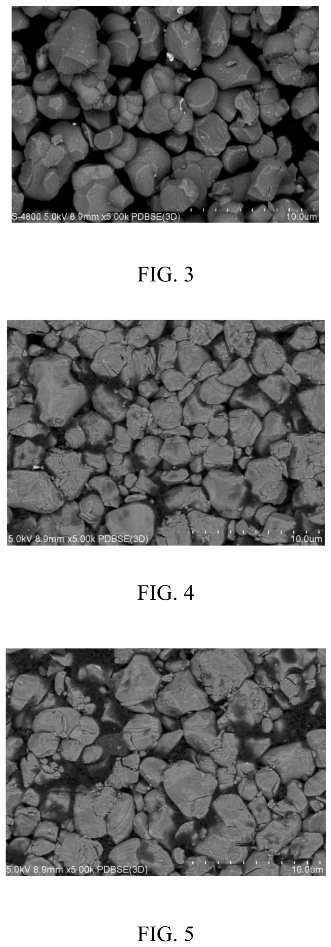

FIG. 3, FIG. 4, and FIG. 5 are SEM images of the cathode materials of Example 1, Comparative Example 1, and Comparative Example 2 after pressure test, respectively. The figures reveal that: after the pressure test, the cathode material particles of Example 1 had almost no cracks in the individual particles, while the cathode material particles of Comparative Example 1 and Comparative Example 2 had different degrees of cracks appearing, the pattern of which was consistent with the pattern of the Youngs modulus test, confirming that the material particles had low strength.

In Example 2, the size of the single crystal particles is slightly smaller, and the transmission distance of the ions is shorter, resulting in a slight increase in the capacity of the battery.

In Example 3, the content of Ni is relatively high, and under the same test system, the capacity of the battery is higher than those of the examples with lower contents of Ni.

In Example 5, due to the high temperature, the particle size exceeds the upper limit. The extremely high temperature and large particle size will reduce the particle strength of the material, and make the material easier to break. In this way, the Youngs modulus test value is low. At the same time, due to the large particle size, the transmission ability of the lithium ions will be reduced. As a result, the electrical performance data such as capacity and impedance are also poor.

Compared with Example 1, the addition amount of the additive in Example 4 is larger, resulting in a relatively high coating ratio. A large amount of the coating agent gives the material a larger particle strength (Youngs modulus value), but the number of interfaces through which electrons are transmitted will also increase. Therefore, the initial impedance value and growth rate are both increased.

The preferred embodiments of the present disclosure are described in detail above. However, the present disclosure is not limited thereto. Within the scope of technical conception of the present disclosure, a variety of simple variations may be made to the technical solutions of the present disclosure, including the combination of various technical features in any other suitable manner. These simple variations and combinations shall be regarded as the contents disclosed by the present disclosure, and all of them fall within the scope of protection of the present disclosure.

**Claims**

1. A single crystal cathode material, wherein:

   the single crystal cathode material has a size distribution $B_{90}=(P_{90}-P_{10})/P_{50}$ of single crystal particles satisfying $0.9 \leq B_{90} \leq 1.4$, where $P_{10}$ is a particle size corresponding to cumulative single crystal particle size distribution percentage in a Scanning Electron Microscope, SEM, image of the cathode material reaching 10%, $P_{50}$ is a particle size corresponding to the cumulative single crystal particle size distribution percentage in the SEM image of the cathode material reaching 50%, and $P_{90}$ is a particle size corresponding to the cumulative single crystal particle size distribution percentage in the SEM image of the cathode material reaching 90%; and
a Youngs modulus E of the cathode material, measured by Atomic Force Microscopy, satisfies 100 GPa$\leq$E$\leq$200 GPa.

2. The single crystal cathode material according to claim 1, wherein:

$$1 \leq B_{90} \leq 1.3;$$

preferably, 120 GPa $\leq$E$\leq$200 GPa; and
preferably, 1 $\mu$m$\leq P_{50} \leq$2 $\mu$m, and preferably, 1.3 $\mu$m$\leq P_{50} \leq$1.7 $\mu$m.

3. The single crystal cathode material according to claim 1 or 2, wherein:

a coating ratio X of the cathode material, measured by SEM, satisfies 5%$\leq$X, and preferably, 5%$\leq$X$\leq$30%;
preferably, a residual stress of the cathode material, measured by X-Ray Diffraction, XRD, ranges from 0% to 0.2%;
preferably, a median particle size $D_{50}$ of the cathode material, measured by a particle size analyzer, satisfies 2 $\mu$m$\leq D_{50} \leq$6 $\mu$m;
preferably, a particle size change rate $\Delta D_{10}=D_{10}-D_{10}$ of the cathode material subsequent to a pressure treatment at 400 MPa, measured by a particle size analyzer, satisfies $\Delta D_{10} \leq$0.2 $\mu$m, where $D_{10}$ is a particle size prior to the pressure treatment, and $D_{10}$ is a particle size subsequent to the pressure treatment; and
preferably, the cathode material has a compaction density ranging from 3.3 g/cm$^3$ to 3.7 g/cm$^3$.

4. The single crystal cathode material according to any one of claims 1 to 3, wherein the single crystal cathode material has a composition represented by Formula I:

$Li_{1+a}(Ni_xMn_yCo_zG_b)M_cO_2$ Formula I, where:

$$0 \leq a \leq 0.2, \ 0 < b \leq 0.05, \ 0 < c \leq 0.05, \ 0.4 \leq x < 1, \ 0 < y < 0.5, \ \text{and} \ 0 \leq z < 0.5;$$

M is selected from at least one of B, Nb, Co, Mo, W, Si, Mg, and Al; and
G is selected from at least one of Ta, Nb, Hf, Zr, Ti, Al, W, Y, Sb, Sr, and Si.

5. A method for preparing the single crystal cathode material according to any one of claims 1 to 4, the method comprising:

S1, mixing a nickel-cobalt-manganese precursor, a lithium source, and an additive optionally containing element G, to obtain a mixture I;
S2, performing, in the presence of an oxygen-containing atmosphere, a first sintering and crushing on the mixture I, to obtain a single crystal cathode material process product II;
S3, mixing the single crystal cathode material process product II with a coating agent optionally containing element M, to obtain a mixture III; and
S4, performing, in the presence of an oxygen-containing atmosphere, a second sintering on the mixture III, to obtain the single crystal cathode material; wherein:
said crushing enables the size distribution $B_{90}=(P_{90}-P_{10})/P_{50}$ of single crystal particles of the single crystal cathode material to satisfy 0.9$\leq B_{90} \leq$1.4, where:

$P_{10}$ is a particle size corresponding to cumulative single crystal particle size distribution percentage in an SEM image of the cathode material reaching 10%, $P_{50}$ is a particle size corresponding to the cumulative single crystal particle size distribution percentage in the SEM image of the cathode material reaching 50%, and $P_{90}$ is a particle size corresponding to the cumulative single crystal particle size distribution percentage in the SEM image of the cathode material reaching 90%; and
the first sintering comprises: a sintering temperature of T/°C, a duration for a temperature-rising section from 400°C to T being $t_1$/h, a duration for a temperature-falling section from T to 400°C being $t_2$/h, and $t_2$ satisfying [ln(T-400)]/$t_2 \leq$1.

6. The method according to claim 5, wherein:

$$0 < t_1/t_2 \leq 1;$$

and/or

$$800°C \leq T \leq 1000°C.$$

7. The method according to claim 5 or 6, wherein:

in step S1, the additive containing the element G is selected from at least one of an oxide of element G, a hydroxide of element G, and a carbonate of element G;
preferably, the element G is selected from at least one of Ta, Nb, Hf, Zr, Ti, Al, W, Y, Sb, Sr, and Si;
preferably, the element G satisfies $E_{G-O} \geq 500$ kJ/mol, where $E_{G-O}$ is a bond energy of G-O; and
preferably, amounts of the nickel-cobalt-manganese precursor, the lithium source, and the additive containing the element G satisfy $1 < n(Li)/[n(Ni)+n(Co)+n(Mn)] < 1.2$ and $0 \leq n(G)/[n(Ni)+n(Co)+n(Mn)] \leq 0.05$.

8. The method according to any one of claims 5 to 7, wherein:

the element M is selected from at least one of B, Nb, Co, Mo, W, Si, Mg, and Al; and
preferably, amounts of the single crystal cathode material process product II and the coating agent containing the element M satisfy $0 \leq n(M)/[n(Ni)+n(Co)+n(Mn)] \leq 0.05$.

9. The method according to any one of claims 5 to 8, wherein conditions for the second sintering comprise: a sintering temperature ranging from 300°C to 800°C and a sintering duration ranging from 4 hours to 12 hours.

10. A lithium-ion battery, comprising the single crystal cathode material according to any one of claims 1 to 4.

FIG. 1

FIG. 2

FIG. 3

FIG. 4

FIG. 5

## INTERNATIONAL SEARCH REPORT

| International application No. |
|---|
| **PCT/CN2023/142331** |

### A. CLASSIFICATION OF SUBJECT MATTER

H01M4/36(2006.01)i; H01M4/505(2010.01)i; H01M4/525(2010.01)i; C30B1/00(2006.01)i

According to International Patent Classification (IPC) or to both national classification and IPC

### B. FIELDS SEARCHED

Minimum documentation searched (classification system followed by classification symbols)

IPC/CPC:H01M4/-,C30B1/-

Documentation searched other than minimum documentation to the extent that such documents are included in the fields searched

Electronic data base consulted during the international search (name of data base and, where practicable, search terms used)

CNTXT, DWPI, ENTXTC, WPABS, 中国期刊网全文数据库, CJFD, ISI-Web of Science, STN: 锂离子电池, 锂电池, 锂离子二次电池, 单晶, 包封, 壳, 掺, 镍, 锰, 钴, 正极, 阴极, 杨氏模量, 冷却速率, 冷却速度, 冷却时间, 降温速率, 降温速度, 降温时间, 直径, 粒径, lithium-ion batter+, lithium-ion secondary batter+, single crystal+, shell, coat+, dop+, Ni, Mn, Co, cathode, positive electrode, yang's modulus, cooling rate, cooling time, diameter

### C. DOCUMENTS CONSIDERED TO BE RELEVANT

| Category* | Citation of document, with indication, where appropriate, of the relevant passages | Relevant to claim No. |
|---|---|---|
| Y | CN 114703544 A (BEIJING EASPRING MATERIAL TECHNOLOGY CO., LTD.) 05 July 2022 (2022-07-05) description, paragraphs 35-63 | 1-4, 10 |
| A | CN 114703544 A (BEIJING EASPRING MATERIAL TECHNOLOGY CO., LTD.) 05 July 2022 (2022-07-05) description, paragraphs 35-63 | 5-9 |
| Y | CN 112447939 A (CONTEMPORARY AMPEREX TECHNOLOGY CO., LTD.) 05 March 2021 (2021-03-05) description, paragraphs 18, 19, 27, 46-52, and 60-62 | 1-4, 10 |
| A | CN 112447939 A (CONTEMPORARY AMPEREX TECHNOLOGY CO., LTD.) 05 March 2021 (2021-03-05) description, paragraphs 18, 19, 27, 46-52, and 60-62 | 5-9 |

☑ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **25 July 2024** | **01 August 2024** |

| Name and mailing address of the ISA/CN | Authorized officer |
|---|---|
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| International application No. |
| --- |
| **PCT/CN2023/142331** |

### C. DOCUMENTS CONSIDERED TO BE RELEVANT

| Category* | Citation of document, with indication, where appropriate, of the relevant passages | Relevant to claim No. |
| --- | --- | --- |
| A | CN 112030220 A (SOUNDON NEW ENERGY TECHNOLOGY CO., LTD.) 04 December 2020 (2020-12-04)<br>entire description | 1-10 |
| A | WO 2023242087 A1 (UMICORE) 21 December 2023 (2023-12-21)<br>entire description | 1-10 |
| A | CN 109309229 A (LIONANO INC.) 05 February 2019 (2019-02-05)<br>entire description | 1-10 |
| A | CN 111682170 A (GUANGDONG BRUNP RECYCLING TECHNOLOGY CO., LTD. et al.) 18 September 2020 (2020-09-18)<br>entire description | 1-10 |
| A | CN 116230916 A (WANHUA CHEMICAL (YANTAI) BATTERY MATERIAL TECHNOLOGY CO., LTD.) 06 June 2023 (2023-06-06)<br>entire description | 1-10 |
| A | KR 20110061204 A (L&F ADVANCED MATERIALS CO., LTD.) 09 June 2011 (2011-06-09)<br>entire description | 1-10 |

Form PCT/ISA/210 (second sheet) (July 2022)

## INTERNATIONAL SEARCH REPORT
### Information on patent family members

| International application No. |
| PCT/CN2023/142331 |

| Patent document cited in search report | | | Publication date (day/month/year) | Patent family member(s) | | | Publication date (day/month/year) |
|---|---|---|---|---|---|---|---|
| CN | 114703544 | A | 05 July 2022 | WO | 2022207008 | A1 | 06 October 2022 |
| | | | | US | 2023202866 | A1 | 29 June 2023 |
| | | | | EP | 4159897 | A1 | 25 April 2023 |
| | | | | JP | 2023540162 | A | 22 September 2023 |
| | | | | JP | 7398015 | B2 | 13 December 2023 |
| | | | | KR | 20230098502 | A | 04 July 2023 |
| | | | | KR | 102669854 | B1 | 27 May 2024 |
| CN | 112447939 | A | 05 March 2021 | WO | 2021042989 | A1 | 31 October 2021 |
| | | | | EP | 3993095 | A1 | 04 May 2022 |
| | | | | US | 2022185697 | A1 | 16 June 2022 |
| CN | 112030220 | A | 04 December 2020 | None | | | |
| WO | 2023242087 | A1 | 21 December 2023 | WO | 2023242087 | A9 | 25 April 2024 |
| CN | 109309229 | A | 05 February 2019 | None | | | |
| CN | 111682170 | A | 18 September 2020 | None | | | |
| CN | 116230916 | A | 06 June 2023 | None | | | |
| KR | 20110061204 | A | 09 June 2011 | KR | 101145951 | B1 | 15 May 2012 |

Form PCT/ISA/210 (patent family annex) (July 2022)